# EUROPEAN PATENT APPLICATION

(11) **EP 4 808 306 A1**
(43) Date of publication of application: **16.09.2026**
(21) Application number: 26164685.5
(22) Date of filing: 13.03.2026
(51) Int. Cl.: H10D 30/01, H10D 30/66, H10D 62/00, H10D 62/10, H10D 62/832, H10D 64/23

(54) **POWER TRANSISTOR AND MANUFACTURING METHOD THEREOF**

(30) Priority: 13.03.2025 TW 114109328
(71) Applicant: Wang, Pei-Ju, Zhonghe New Taipei City 235021 (TW)
(72) Inventor: LO VERDE, Domenico, 95123 Catania (IT); RONSISVALLE, Cesare, 95030 Pedara (IT); HSH, Huang-Pin, 048693 Singapore (SG); HUANG, Zi-Hao, 048693 Singapore (SG); HSIEH, Sung-Ying, 048693 Singapore (SG)
(74) Representative: Patentanwaltskanzlei WILHELM & BECK

(57) **Abstract**

The present invention involves a power device and a manufacturing method thereof. The method comprising steps of providing a semiconductor substrate (12), growing stacked epitaxial layers (1012, 1013, 1014) on the semiconductor substrate, selectively etching the epitaxial layer to define an active cell region (ACR), protection area (PA) and transition structure, forming an isolation layer mask (ISO) on the epitaxial layer, performing an ion implantation process above the isolation mask on epitaxial layers (1012, 1013). Forming drain (1016), source (S1) and gate contacts.

## Description

This application claims the priority of Taiwan Application No. 114109328, filed on March 13, 2025, the disclosures of which are incorporated herein in their entirety by reference.

The present disclosure relates to a power transistor and a manufacturing method thereof, and more particularly to a method for manufacturing a power transistor that reduces process complexity, reduces process steps and cost, and improves productivity, and the power transistor manufactured using the method.

In the conventional manufacturing process of a SiC MOSFET, it is necessary to etch a silicon carbide (SiC) semiconductor substrate to form a plurality of trenches and a protection region on the substrate, and subsequently perform high-energy ion implantation on the SiC semiconductor substrate to dope the SiC semiconductor substrate, thereby defining an active region, a source, a body diode, a floating edge guard ring, and other structures of the power transistor. However, due to the high density of the SiC material, it is almost impossible to introduce any dopant into the SiC material by thermal diffusion, and the dopant can only be forcibly implanted using an ion implanter. The energy required for the ion implantation performed on the SiC semiconductor substrate is very high, and the implantation process is also time-consuming. In addition, it is necessary to consider forming a specific mask in a selective region with a specific material to shield the high-energy ion implantation, which further increases the complexity of the process. Therefore, the conventional manufacturing process of a SiC MOSFET not only involves a more complicated sequence of steps, higher cost, and time-consuming and labor-intensive procedures, but also results in reduced productivity.

Therefore, in view of the deficiencies in the prior art, the applicants of the present application developed the present invention "power transistor and manufacturing method thereof" to overcome the disadvantages of conventional technologies. The descriptions of the present invention are as follows:

In view of the foregoing, the present disclosure provides a method for manufacturing a power transistor, in which at least one carrier layer is pre-formed on a silicon carbide semiconductor substrate to define an active region, a source, a body diode, a floating edge guard ring, and other structures of the power transistor. The carrier layer may be formed by growing an epitaxial layer on a general SiC semiconductor substrate. During epitaxial growth, a chemical vapor deposition (CVD) process is employed, and dopant materials are mixed into the atmosphere within a sealed chamber. By controlling the flow rate of the materials, the desired doping concentration can be achieved. This preparation process may be carried out by semiconductor material suppliers and incurs only a slightly higher cost compared to conventional materials. In contrast, it is significantly more economical than the subsequent complex and time-consuming steps of the process. Moreover, by reducing process complexity and shortening processing time, production efficiency can be improved.

In one aspect, the present invention provides a method for manufacturing a power transistor. The method comprises the following steps: providing a silicon carbide semiconductor substrate, wherein the silicon carbide semiconductor substrate comprises a first type highly doped silicon carbide layer, a first type silicon carbide epitaxial layer, a second type silicon carbide epitaxial layer, and a first type highly doped silicon carbide epitaxial layer, the second type silicon carbide epitaxial layer being pre-arranged on the first type silicon carbide epitaxial layer to serve as an active channel of the power transistor, and the first type highly doped silicon carbide epitaxial layer being pre-arranged on the second type silicon carbide epitaxial layer to serve as a first electrode of the power transistor; etching the first type highly doped silicon carbide epitaxial layer, the second type silicon carbide epitaxial layer, and the first type silicon carbide epitaxial layer to form a protection area base and an active cell region base having at least one trench; depositing a gate isolation layer on the protection area base and the active cell region base; depositing a polysilicon on each of the at least one trench to form at least one gate; depositing a first isolation layer on the protection area base and the active cell region base; and etching the first isolation layer, the gate isolation layer, the first type highly doped silicon carbide epitaxial layer, and the second type silicon carbide epitaxial layer located between the at least one trench and between the active cell region base and the protection area base, and etching the first isolation layer and the gate isolation layer in a plurality of spaced portions of the protection area base.

In another aspect, the present invention provides a method of manufacturing a power transistor. The method comprises the following steps: providing a semiconductor substrate, wherein the semiconductor substrate comprises a first type highly doped semiconductor layer, a first type epitaxial layer, a second type epitaxial layer, and a first type highly doped epitaxial layer, wherein the second type epitaxial layer is pre-arranged on the first type epitaxial layer to serve as an active channel of the power transistor, and the first type highly doped epitaxial layer is pre-arranged on the second type epitaxial layer to serve as a first electrode of the power transistor; and etching the first type highly doped epitaxial layer, the second type epitaxial layer, and the first type epitaxial layer to form a protection area base and an active cell region base having at least one trench.

In another aspect, the present invention provides a method of manufacturing a power transistor. The method comprises the following steps: providing a semiconductor substrate comprising a first epitaxial layer and a second epitaxial layer, wherein the second epitaxial layer is pre-arranged on the first epitaxial layer to serve as an electronic component layer of the power transistor; and etching the second epitaxial layer and the first epitaxial layer to form a protection area base and an electronic component layer substrate having at least one trench.

In another aspect, the present invention provides a power transistor. The power transistor comprises a semiconductor substrate comprising a first type epitaxial layer; an active cell disposed on the semiconductor substrate and comprising at least one gate; a protection structure disposed on the semiconductor substrate; and a transition structure. On two sides of the at least one gate, there are a second type epitaxial portion on the first type epitaxial layer and a first type highly doped epitaxial portion on the second type epitaxial portion. The transition structure is disposed between the active cell and the protection structure, and has a second type highly doped epitaxial portion.

The embodiments and advantages of the present invention will become more readily apparent to those ordinarily skilled in the art after reviewing the following detailed descriptions and accompanying drawings.
Fig. 1 to Fig. 12 are schematic diagrams showing cross-sectional views in sequential steps of a method for manufacturing a power transistor according to a preferred embodiment of the present disclosure.
Fig. 13 is a flow chart illustrating a method for manufacturing a power transistor according to a preferred embodiment of the present disclosure.
Fig. 14 is a flow chart illustrating a method for manufacturing a power transistor according to another preferred embodiment of the present disclosure.
Fig. 15 is a flow chart illustrating a method for manufacturing a power transistor according to another preferred embodiment of the present disclosure.

The present invention will now be described more specifically with reference to the following embodiments.

Unless otherwise limited or described in a specific example, the following definitions apply to terms used throughout this specification.

The term "comprising" or "comprises" as used herein means that in addition to the described components, steps, and/or elements, the presence of one or more other components, steps, and/or elements is not excluded.

The term "about" as used herein means there is a close or allowable error range to prevent the present invention from being limited to the exact or absolute numerical values disclosed. The term "a" used herein means that the object of the article is one or more than one.

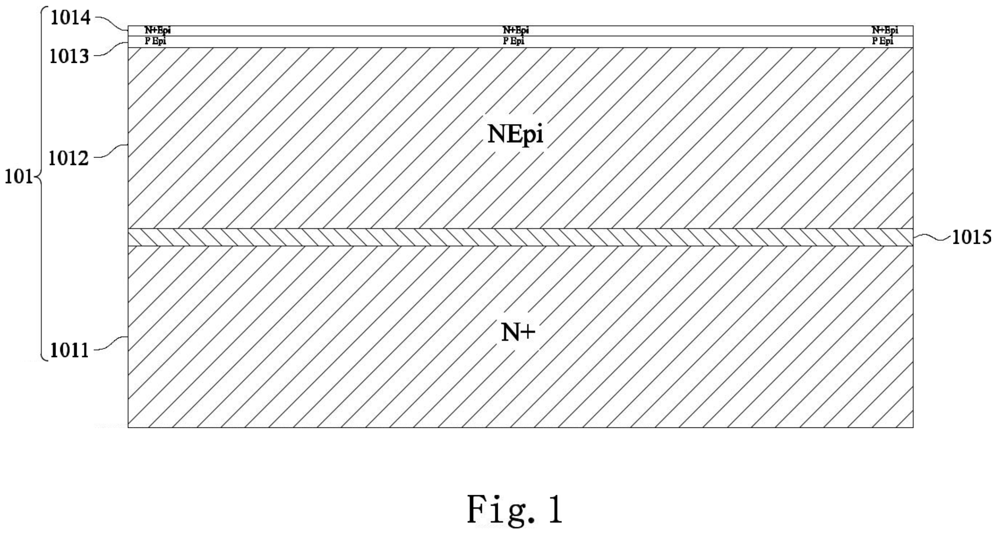

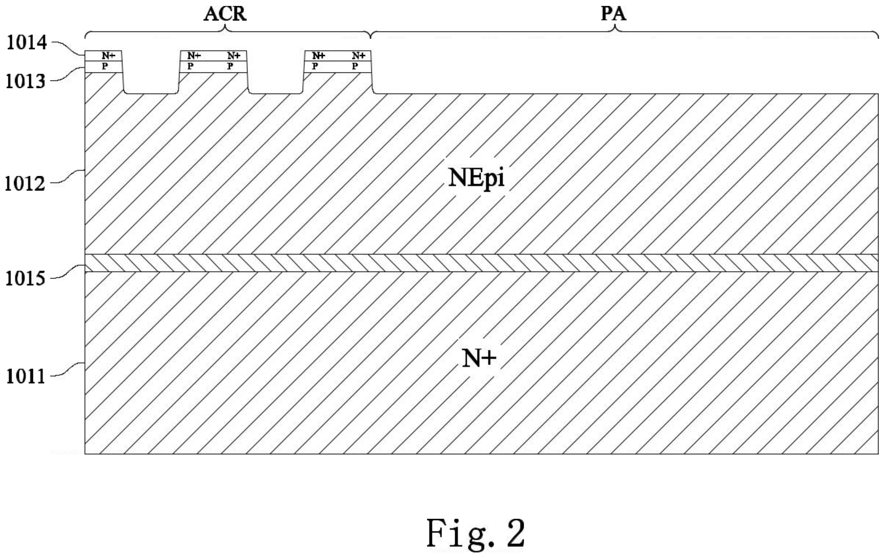

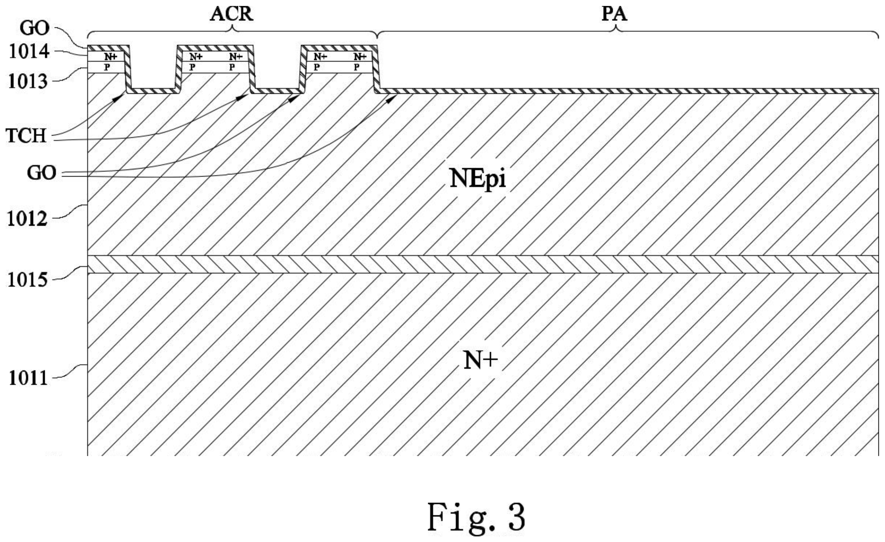

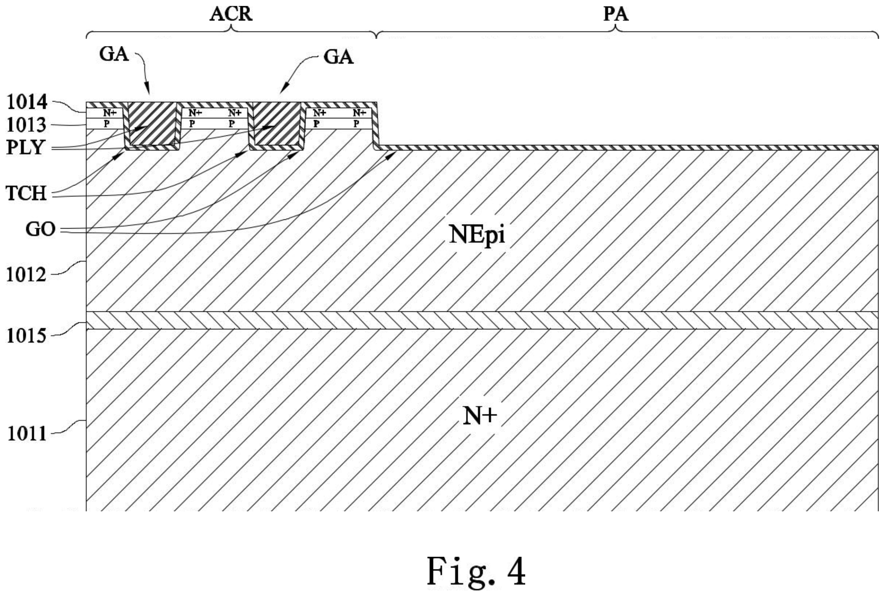

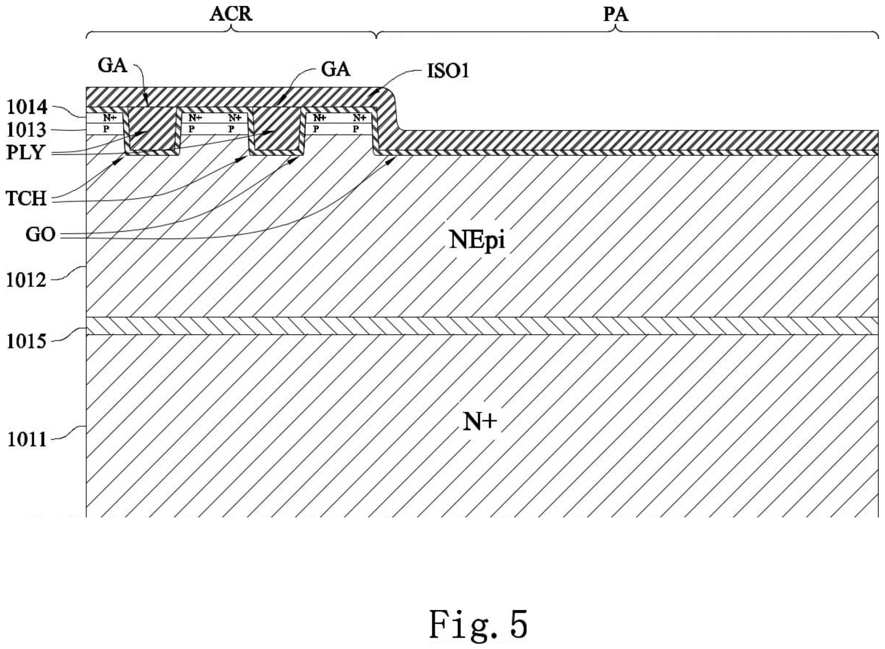

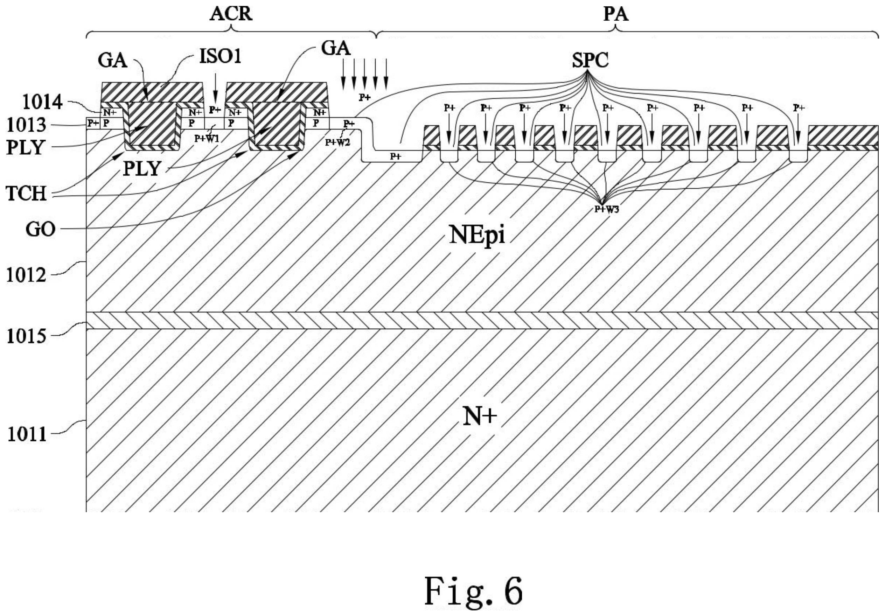

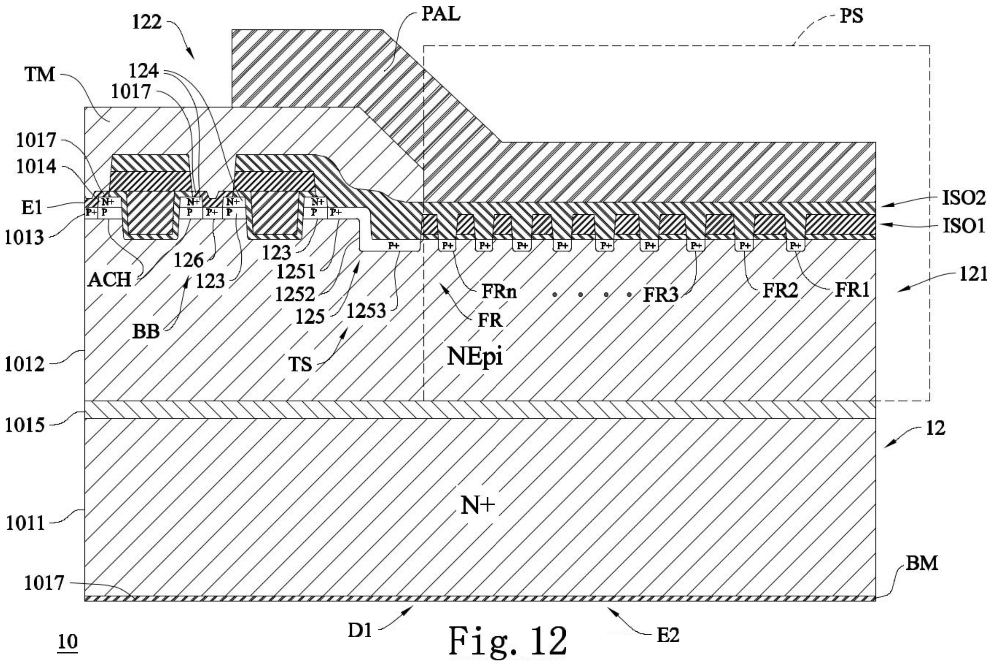

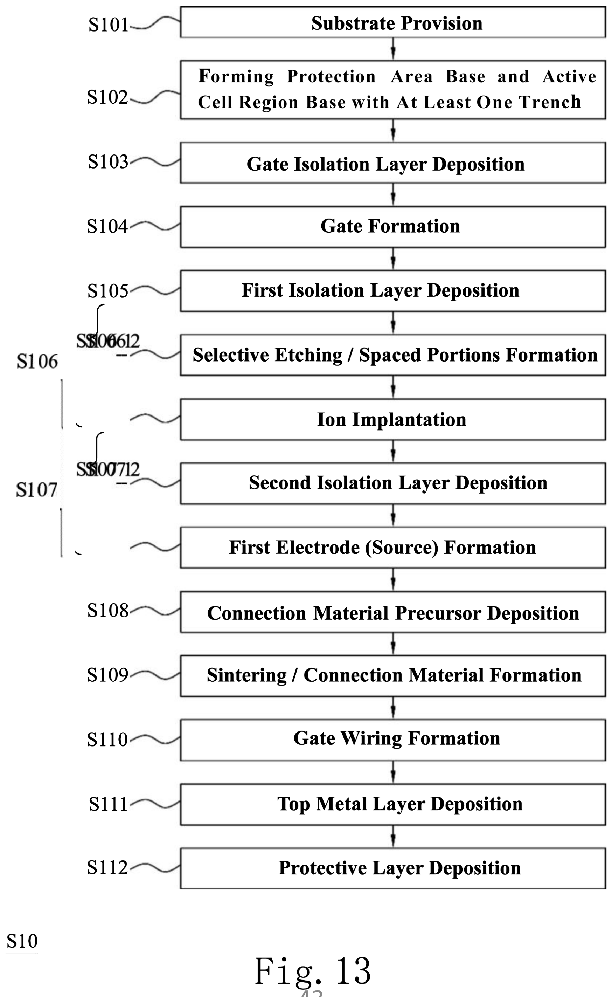

Please refer to Fig. 1 to Fig. 13. Fig. 1 to Fig. 12 are schematic diagrams showing cross-sectional views in sequential steps of a method (e.g., the method in Fig. 13) for manufacturing a power transistor according to a preferred embodiment of the present disclosure. Fig. 13 is a flow chart illustrating a method S10 for manufacturing a power transistor according to a preferred embodiment of the present disclosure. The method S10 for manufacturing a power transistor 10 (as shown in Fig. 12) comprises the following steps:
Step S101, as shown in Fig. 1, includes providing a silicon carbide (SiC) semiconductor substrate 101. The SiC semiconductor substrate 101 includes a first type highly doped SiC layer 1011, a first type SiC epitaxial layer 1012, a second type SiC epitaxial layer 1013, and a first type highly doped SiC epitaxial layer 1014. The second type SiC epitaxial layer 1013 is pre-arranged on the first type SiC epitaxial layer 1012 to serve as an active channel ACH of a power transistor 10, and the first type highly doped SiC epitaxial layer 1014 is pre-arranged on the second type SiC epitaxial layer 1013 to serve as a first electrode E1 of the power transistor 10, as shown in Fig. 12.
Step S102, as shown in Fig. 2, includes etching the first type highly doped SiC epitaxial layer 1014, the second type SiC epitaxial layer 1013, and the first type SiC epitaxial layer 1012 to form a protection area base (PA) and an active cell region base ACR having at least one trench TCH.
Step S103, as shown in Fig. 3, includes depositing a gate isolation layer GO on the protection area base PA and the active cell region base ACR.
Step S104, as shown in Fig. 4, includes depositing a polysilicon PLY on each trench of the at least one trench TCH to form at least one gate GA.
Step S105, as shown in Fig. 5, includes depositing a first isolation layer ISO1 on the protection area base PA and the active cell region base ACR.
Step S106-1, as shown in Fig. 6, includes etching the first isolation layer ISO1, the gate isolation layer GO, the first type highly doped SiC epitaxial layer 1014, and the second type SiC epitaxial layer 1013 between the at least one trench TCH and between the active cell region base ACR and the protection area base PA, and etching the first isolation layer ISO1 and the gate isolation layer GO spaced portion in the protection area base PA at a plurality of intervals to form a plurality of spaced portions SPC. The width of the plurality of spaced portions SPC in the protection area base PA increases as it is closer to an edge of the protection area base PA.

In any embodiment of the present disclosure, the method S10 further includes the following step. Step S106-2, as shown in Fig. 6, includes implanting a second type carrier P+ into the first type SiC epitaxial layer 1012 between the at least one gate GA, between the active cell region base ACR and the protection area base PA, and in the plurality of spaced portions SPC of the protection area base PA to form a plurality of second type highly doped semiconductor wells. The second type highly doped semiconductor wells include a first highly doped semiconductor well P+W1 formed in the first type SiC epitaxial layer 1012 between adjacent two gates (or between adjacent trenches TCH) of the at least one gate GA; a second highly doped semiconductor well P+W2 formed in the first type SiC epitaxial layer 1012 between the active cell region base ACR and the protection area base PA; and a third highly doped semiconductor well P+W3 formed in the first type SiC epitaxial layer 1012 in the plurality of spaced portions SPC. A plurality of PN junctions (not shown) are formed between the second highly doped semiconductor well P+W2 and the first type SiC epitaxial layer 1012, wherein the plurality of PN junctions are configured to buffer a working high voltage in a reverse bias. In Fig. 1 to Fig. 12, the SiC semiconductor substrate 101 further includes a buffer layer 1015 connecting the first type highly doped SiC layer 1011 and the first type SiC epitaxial layer 1012.

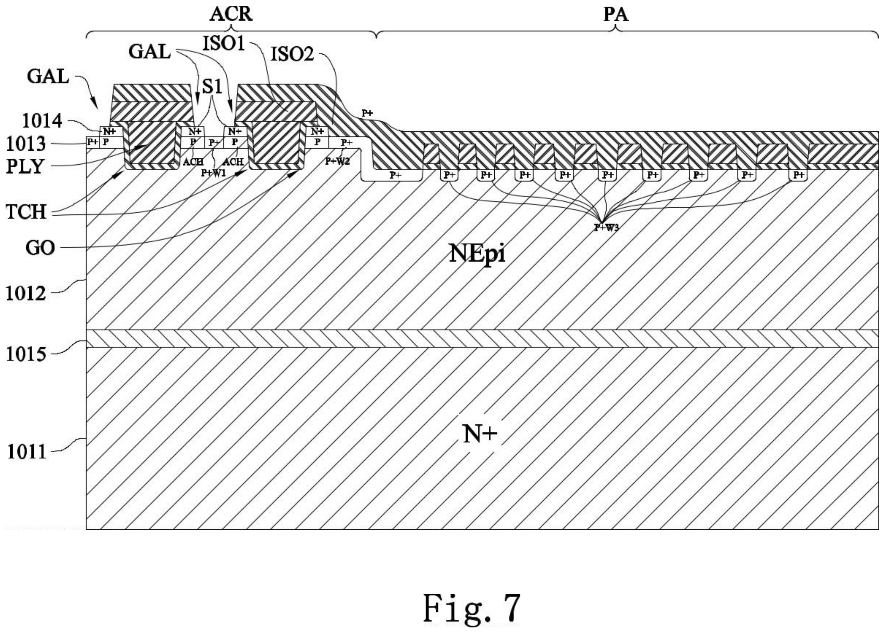

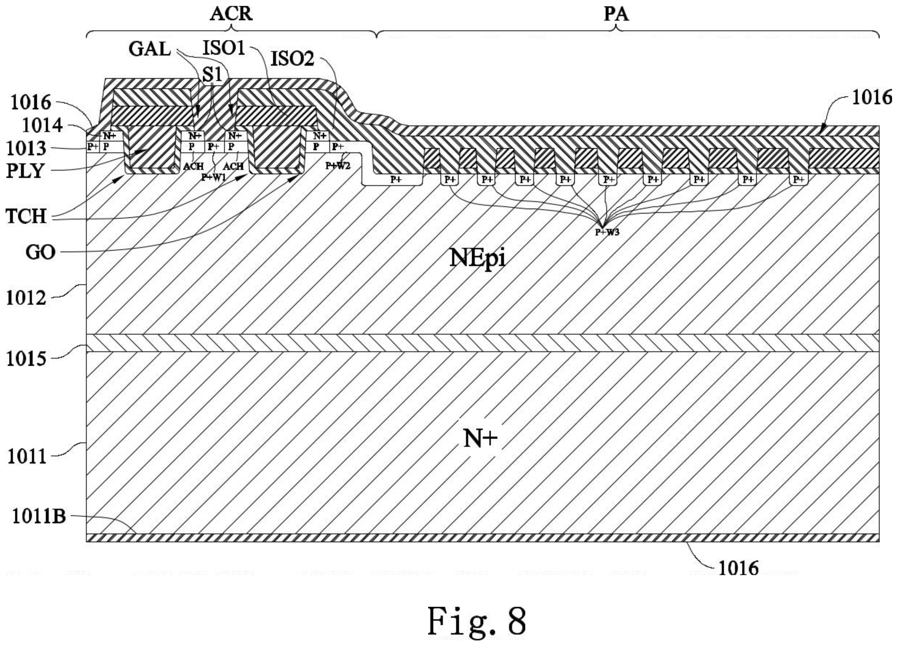

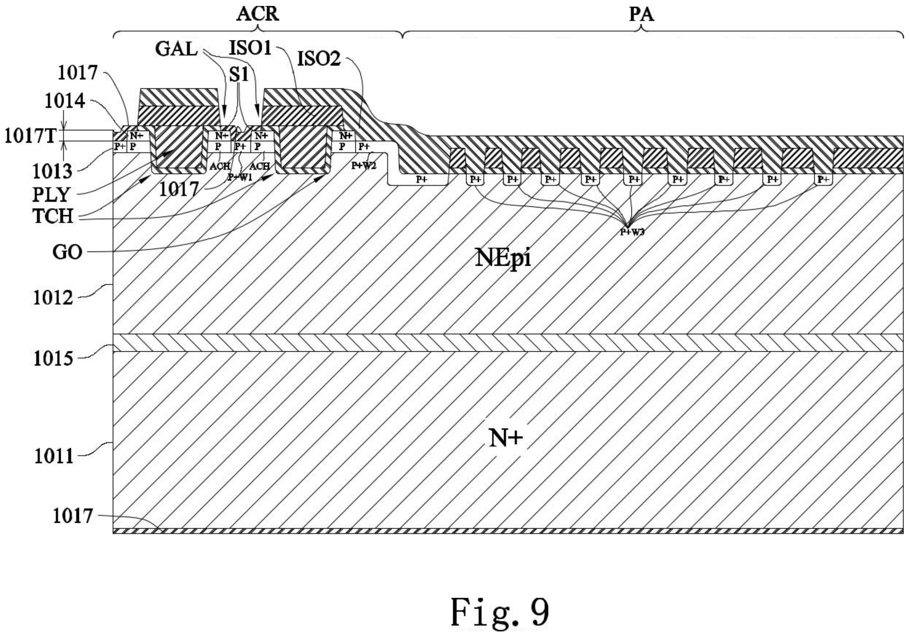

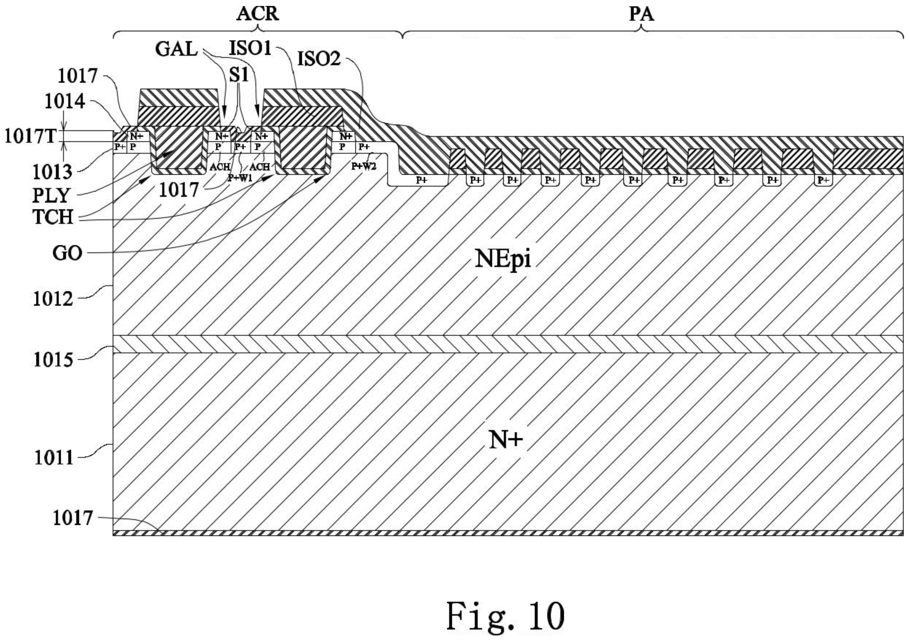

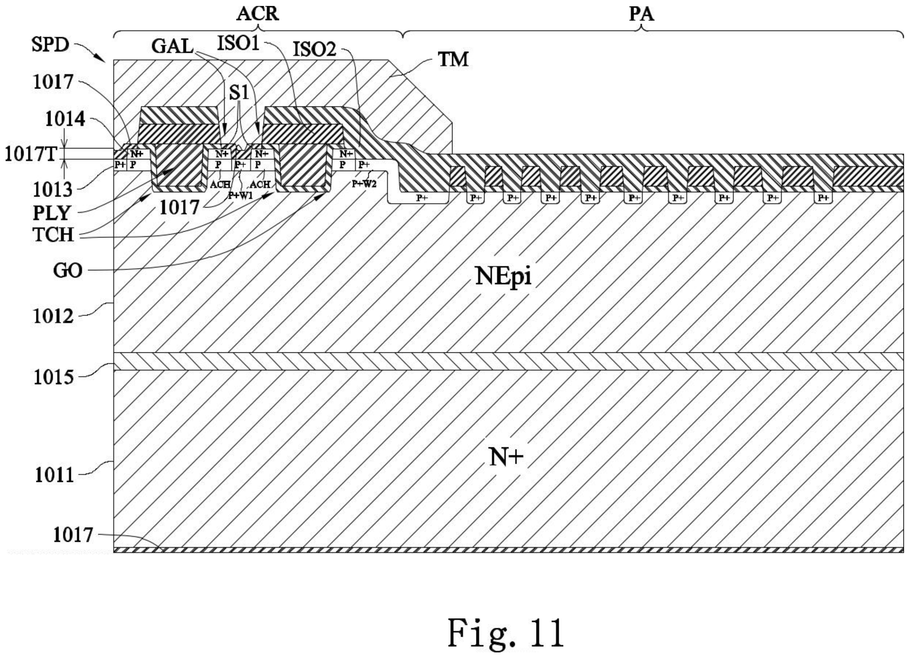

In any embodiment of the present disclosure, the method S10 further includes the following steps:
Step S107-1, as shown in Fig. 7, includes depositing a second isolation layer ISO2 on the first isolation layer ISO1 and the plurality of spaced portions SPC of the protection area base PA. In an embodiment, the material of the first and second isolation layers may be silicon dioxide.
Step S107-2, as shown in Fig. 7, includes etching the first isolation layer ISO1 and the second isolation layer ISO2 on the two sides GAL of each gate GA, so that the first type highly doped SiC epitaxial layer 1014 on the two sides GAL is exposed to form the first electrode E1, wherein the second type SiC epitaxial layer 1013 on the two sides GAL serves as the active channel ACH, and the first electrode E1 (as shown in Fig. 12) is a source S1.
Step S108, as shown in Fig. 8, includes depositing a connecting material precursor 1016 on the active cell region base ACR, the protection area base PA, and the bottom 1011B of the first type highly doped SiC layer 1011. In an embodiment, the connecting material precursor 1016 is a nickel metal.
Step S109, as shown in Fig. 9, includes etching the connecting material precursor 1016 on the protection area base PA, and etching the connecting material precursor 1016 between adjacent two gates GA to have a specific thickness 1017T, and sintering the connecting material precursor 1016 with the specific thickness 1017T to form a connecting material 1017, wherein the connecting material is nickel silicide.
Step S110, as shown in Fig. 10, includes etching a gate contact pad (not shown) to form a gate contact pad opening (not shown), and filling a gate wire material into the gate contact pad opening (not shown). The gate wire material may be an aluminum metal. The gate contact pad, the gate contact pad opening, and the gate wire material in Fig. 10 protrude from the plane of the paper, and thus are not shown in the cross-section of Fig. 10.
Step S111, as shown in Fig. 11, includes depositing a top metal layer TM on the second isolation layer ISO2 of the active cell region base ACR and on the connecting material 1017 between adjacent two gates GA, wherein the top metal layer TM serves as a source electrode pad (SPD).
Step S112, as shown in Fig. 12, includes depositing a protection layer PAL on the protection area base PA and a part of the top metal layer TM in the active cell region ACR. In Fig. 12, the connecting material 1017 at the bottom 1101B of the first type highly doped SiC layer 1011 can be electroplated with silver metal to serve as a drain D1 of the power transistor 10.

In Fig. 12, the power transistor 10 includes a semiconductor substrate 12, a protection structure PS, and a transition structure TS. The power transistor 10 includes a first type epitaxial layer 121 and includes an active cell 122. The active cell 122 is arranged on the semiconductor substrate 12 and includes at least one gate GA. On two sides GAL of the gate GA, there are a second type epitaxial portion 123 on the first type epitaxial layer 121 and a first type highly doped epitaxial portion 124 on the second type epitaxial portion 123. The protection structure PS is arranged on the semiconductor substrate 12. The transition structure TS is arranged between the active cell 122 and the protection structure PS, and has a second type highly doped epitaxial portion 125.

In any embodiment of the present disclosure, the active cell 122 further includes a second type highly doped epitaxial portion 126, which is arranged between any two adjacent gates GA and between any two second type epitaxial portions 123, wherein the second type highly doped epitaxial portion 126 is configured to serve as a body base BB of the power transistor 10, and the second type epitaxial portions 123 serve as an active region of the power transistor 10. The transition structure TS is configured to serve as a single-level PN diode, which protects the power transistor 10 when the single-level PN diode is reverse-biased, and includes the first type epitaxial layer 121, a first position portion 1251 arranged on the first type epitaxial layer 121, a second position portion 1253 (the horizontal position of the second position portion 1253 is lower than the first position portion 1251) arranged on the first type epitaxial layer 121, and a step transition portion 1252 arranged on the first type epitaxial layer 121 and connecting the first position portion 1251 and the second position portion 1253. The first position portion 1251, the second position portion 1253, and the step transition portion 1252 together form a step shape.

The semiconductor substrate 12 is a SiC semiconductor substrate 101, and the power transistor 10 is a trench power transistor. The first type is N-type, and the second type is P-type. Each gate GA includes a polysilicon PLY arranged in a trench TCH and a gate isolation layer GO arranged on the two sides and the bottom of the trench TCH. The first type highly doped epitaxial portion 124 on the two sides GAL of the gate GA serves as a source S1 of the power transistor 10. The active cell 122 further includes a first isolation layer ISO1 arranged on the gate GA and a top metal layer TM arranged on the active cell 122. The top metal layer TM serves as a source electrode pad (SPD). The first isolation layer ISO1 is configured to isolate the gate GA from the source electrode pad SPD. A part of the source S1 is electrically connected to the source electrode pad SPD. The SiC semiconductor substrate 101 further includes a buffer layer 1015, a first type highly doped SiC layer 1011, and a bottom metal layer BM, wherein the buffer layer 1015 connects the first type highly doped SiC layer 1011 and the first type epitaxial layer 121, and the bottom metal layer BM serves as a drain D1 of the power transistor 10. The protection structure PS is configured to serve as a multi-level PN diode, which protects the power transistor 10 when the multi-level PN diode is reverse-biased. The protection structure PS includes a plurality of floating edge rings FR and a second isolation layer ISO2. Each floating edge ring of the plurality of floating edge rings FR includes second type highly doped epitaxial portions FR1, FR2, ..., FRn, and the second type highly doped epitaxial portions FR1, FR2, ..., FRn form a PN semiconductor junction with a part of the first type epitaxial layer 121. The second isolation layer ISO2 is configured to isolate the plurality of floating edge rings FR from the source electrode pad SPD. The protection layer PAL is arranged on the plurality of floating edge rings FR and the source electrode pad SPD.

It is worth noting that the microstructure of the second type highly doped epitaxial portion 126, which serves as the body base BB of the power transistor 10, is microscopically distinguishable from the microstructure of the second type epitaxial portion 123, which serves as an active region of the power transistor 10 on its adjacent two sides. This difference arises because the body base BB is formed through high-energy ion implantation, whereas the active region is formed by pre-doping P-type dopants using a chemical vapor deposition process during the growth of SiC crystal. Furthermore, the active region is completely fabricated before the etching and micro-development processes are started, which reduces the need for subsequent time-consuming, high-energy ion implantation process steps, thereby saving production time and improving production efficiency.

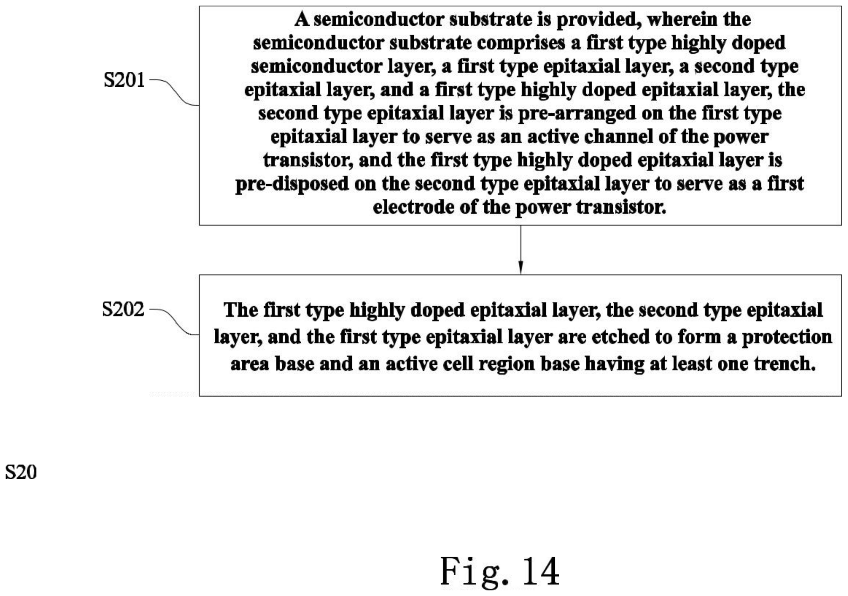

Please refer to Fig. 14, which is a flow chart of a method S20 for manufacturing a power transistor 10 according to another preferred embodiment of the present disclosure. The method S20 includes the following steps. Step S201 includes providing a semiconductor substrate, wherein the semiconductor substrate includes a first type highly doped semiconductor layer, a first type epitaxial layer, a second type epitaxial layer, and a first type highly doped epitaxial layer. The second type epitaxial layer is pre-arranged on the first type epitaxial layer to serve as an active channel of the power transistor 10, and the first type highly doped epitaxial layer is pre-arranged on the second type epitaxial layer to serve as a first electrode of the power transistor 10. Step S202 includes etching the first type highly doped epitaxial layer, the second type epitaxial layer, and the first type epitaxial layer to form a protection area base and an active cell region base having at least one trench.

Step S201 is a step of forming a precursor, and the semiconductor substrate serving as the raw material is already completed before the power transistor 10 is manufactured. The embodiment in Fig. 14 may be combined with any other embodiment of the present disclosure to form a new embodiment. For example, the method S20 may further include the following steps. As shown in Fig. 3, a gate isolation layer GO is deposited on the protection area base PA and the active cell region base ACR. Step S104, as shown in Fig. 4, includes depositing a polysilicon PLY on each trench of the at least one trench TCH to form at least one gate GA. Step S105, as shown in Fig. 5, includes depositing a first isolation layer ISO1 on the protection area base PA and the active cell region base ACR. Step S106-1, as shown in Fig. 6, includes etching the first isolation layer ISO1, the gate isolation layer GO, the first type highly doped SiC epitaxial layer 1014, and the second type SiC epitaxial layer 1013 between adjacent trenches of the at least one trench TCH and between the active cell region base ACR and the protection area base PA, and etching the first isolation layer ISO1 and the gate isolation layer GO in a plurality of spaced portions SPC of the protection area base PA.

In any embodiment of the present disclosure, the method S20 further includes the following steps. Step S106-2, as shown in Fig. 6, includes implanting a second type carrier P+ into the first type SiC epitaxial layer 1012 between gates GA, between the active cell region base ACR and the protection area base PA, and in the plurality of spaced portions SPC of the protection area base PA, so as to form a second type highly doped semiconductor well. The second type highly doped semiconductor well includes a first highly doped semiconductor well P+W1 formed in the first type SiC epitaxial layer 1012 between the adjacent gates GA; a second highly doped semiconductor well P+W2 formed in the first type SiC epitaxial layer 1012 between the active cell region base ACR and the protection area base PA; a third highly doped semiconductor well P+W3 formed in the first type SiC epitaxial layer 1012 in the plurality of spaced portions SPC; and a plurality of PN junctions (not shown) formed between the second highly doped semiconductor well P+W2 and the first type SiC epitaxial layer 1012, wherein the plurality of PN junctions are configured to buffer a working high voltage under a reverse bias condition. In Fig. 1 to Fig. 12, the SiC semiconductor substrate 101 further includes a buffer layer 1015 connecting the first type highly doped SiC layer 1011 and the first type SiC epitaxial layer 1012.

In any embodiment of the present disclosure, the method S20 further includes the following steps. Step S107-1, as shown in Fig. 7, includes depositing a second isolation layer ISO2 on the first isolation layer ISO1 and the plurality of spaced portions SPC of the protection area base PA, wherein the material of the first and second isolation layers may be silicon dioxide. Step S107-2, as shown in Fig. 7, includes etching the first isolation layer ISO1 and the second isolation layer ISO2 on the two sides GAL of each gate of the at least one gate GA, so that the first type highly doped SiC epitaxial layer 1014 on the two sides GAL is exposed to form the first electrode E1, wherein the second type SiC epitaxial layer 1013 on the two sides GAL serves as the active channel ACH, and the first electrode E1 (as shown in Fig. 12) is a source S1. Step S108, as shown in Fig. 8, includes depositing a connecting material precursor 1016 on the active cell region base ACR, the protection area base PA, and the bottom 1011B of the first type highly doped SiC layer 1011, wherein the connecting material precursor 1016 may be a nickel metal. Step S109, as shown in Fig. 9, includes etching the connecting material precursor 1016 on the protection area base PA, etching the connecting material precursor 1016 between two gates GA to have a specific thickness 1017T, and sintering the connecting material precursor 1016 with the specific thickness 1017T to form a connecting material 1017, wherein the connecting material is nickel silicide. Step S110, as shown in Fig. 10, includes etching a gate contact pad (not shown) to form a gate contact pad opening (not shown), and filling a gate wire material into the gate contact pad opening (not shown), wherein the gate wire material may be an aluminum metal. Step S111, as shown in Fig. 11, includes depositing a top metal layer TM on the second isolation layer ISO2 of the active cell region base ACR and on the connecting material 1017 between two gates GA, wherein the top metal layer TM serves as a SPD. Step S112, as shown in Fig. 12, includes depositing a protection layer PAL on the protection area base PA and a part of the top metal layer TM in the active cell region ACR.

In any embodiment of the present disclosure, the semiconductor substrate 12 is a wide bandgap semiconductor substrate. The wide bandgap semiconductor substrate is a SiC semiconductor substrate 101. The first type highly doped semiconductor layer is a first type highly doped SiC layer 1011, the first type epitaxial layer 121 is a first type SiC epitaxial layer 1012, the second type epitaxial layer P Epi (as shown in Fig. 1) is a second type SiC epitaxial layer 1013, and the first type highly doped epitaxial layer N+Epi (as shown in Fig. 1) is a first type highly doped SiC epitaxial layer 1014. The first type is N-type, and the second type is P-type. The SiC semiconductor substrate 101 further includes a buffer layer 1015 connecting the first type highly doped SiC layer 1011 and the first type SiC epitaxial layer 1012. The SiC semiconductor substrate 101 further includes a bottom metal layer BM arranged under the first type highly doped SiC layer 1011 to serve as a second electrode E2 (as shown in Fig. 12) of the power transistor 10, wherein the second electrode E2 is a drain D1 of the power transistor 10. The width of the plurality of spaced portions SPC of the protection area base PA increases as the spaced portions SPC approach an edge of the protection area base PA. The number and width of the plurality of spaced portions SPC depend on a voltage-withstanding specification of the power transistor 10. Before all micro-development processes and all etching processes, the second type SiC epitaxial layer 1013 and the first type highly doped SiC epitaxial layer 1014 are pre-arranged on the first type SiC epitaxial layer 1012 to eliminate or reduce subsequent high-energy ion implantation.

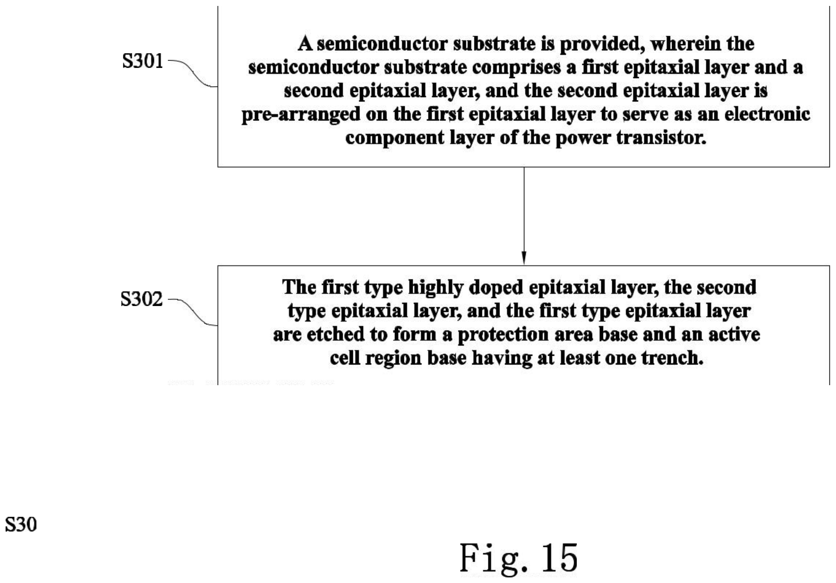

Please refer to Fig. 15, which is a flow chart of a method S30 for manufacturing a power transistor 10 according to another preferred embodiment of the present disclosure. The method S30 includes the following steps. Step S301 includes providing a semiconductor substrate, wherein the semiconductor substrate includes a first epitaxial layer and a second epitaxial layer, wherein the second epitaxial layer is pre-arranged on the first epitaxial layer to serve as an electronic component layer of the power transistor. Step S302 includes etching the second epitaxial layer and the first epitaxial layer to form a protection area baseand an electronic component layer base having at least one trench.

The embodiment in Fig. 15 may be combined with any other embodiment of the present disclosure to form a new embodiment. For example, the semiconductor substrate 12 is a wide bandgap semiconductor substrate. The wide bandgap semiconductor substrate may be a SiC semiconductor substrate 101. The first epitaxial layer is a first type epitaxial layer 121, and the second epitaxial layer includes a first type highly doped epitaxial layer N+Epi and a second type epitaxial layer P Epi (as shown in Fig. 1). The first type is N-type, and the second type is P-type. The semiconductor substrate 12 includes a first type highly doped semiconductor layer, a first type epitaxial layer 121, a second type epitaxial layer P Epi (as shown in Fig. 1), and a first type highly doped epitaxial layer N+Epi (as shown in Fig. 1). The second type epitaxial layer P Epi is pre-arranged on the first epitaxial layer 121 to serve as an active channel ACH of the power transistor 10, and the first type highly doped epitaxial layer N+Epi is pre-arranged on the second type epitaxial layer P Epi to serve as a first electrode E1 of the power transistor 10. The second type epitaxial layer P Epi includes a second type epitaxial portion 123, and the electronic component layer includes the second type epitaxial portion P Epi serving as an active region of the power transistor 10. The electronic component layer base includes an active cell region base ACR and a protection area base PA. The first type highly doped semiconductor layer is a first type highly doped SiC layer 1011, the first type epitaxial layer 121 is a first type SiC epitaxial layer 1012, the second type epitaxial layer P Epi is a second type SiC epitaxial layer 1013, and the first type highly doped epitaxial layer N+Epi is a first type highly doped SiC epitaxial layer 1014. The SiC semiconductor substrate 101 further includes a buffer layer 1015 connecting the first type highly doped SiC layer 1011 and the first type SiC epitaxial layer 1012. The SiC semiconductor substrate 101 further includes a bottom metal layer BM arranged under the first type highly doped SiC layer 1011 to serve as a second electrode E2 of the power transistor 10. The second electrode E2 is a drain D1 of the power transistor 10.

In any embodiment of the present disclosure, the width of the plurality of spaced portions SPC of the protection area base PA is wider as it is closer to an edge of the protection area base PA. The number and width of the plurality of spaced portions SPC depend on a voltage-withstanding specification of the power transistor 10. Before all micro-development processes and all etching processes, the second type SiC epitaxial layer 1013 and the first type highly doped SiC epitaxial layer 1014 are pre-arranged on the first type SiC epitaxial layer 1012 to eliminate or reduce subsequent high-energy ion implantation.

In any embodiment of the present disclosure, the method S30 can be combined with any embodiment of the present disclosure to form another embodiment. For example, the method S30 may further include the following steps. The first type highly doped epitaxial layer 1014, the second type epitaxial layer 1013, and the first type epitaxial layer 1012 are etched to form the protection area base PA and the active cell region base ACR having at least one trench TCH. As shown in Fig. 3, a gate isolation layer GO is deposited on the protection area base PA and the active cell region base ACR. Step S104, as shown in Fig. 4, includes depositing a polysilicon PLY on each trench of the at least one trench TCH to form at least one gate GA. Step S105, as shown in Fig. 5, includes depositing a first isolation layer ISO1 on the protection area base PA and the active cell region base ACR. Step S106-1, as shown in Fig. 6, includes etching the first isolation layer ISO1, the gate isolation layer GO, the first type highly doped SiC epitaxial layer 1014, and the second type SiC epitaxial layer 1013 between adjacent trenches of the at least one trench TCH and between the active cell region base ACR and the protection area base PA, and etching the first isolation layer ISO1 and the gate isolation layer GO in a plurality of spaced portions SPC of the protection area base PA. Step S106-2, as shown in Fig. 6, includes implanting a second type carrier P+ into the first type SiC epitaxial layer 1012 between gates GA, between the active cell region base ACR and the protection area base PA, and in the plurality of spaced portions SPC of the protection area base PA, so as to form a second type highly doped semiconductor well. The second type highly doped semiconductor well includes a first highly doped semiconductor well P+W1 formed in the first type SiC epitaxial layer 1012 between the adjacent gates GA; a second highly doped semiconductor well P+W2 formed in the first type SiC epitaxial layer 1012 between the active cell region base ACR and the protection area base PA; a third highly doped semiconductor well P+W3 formed in the first type SiC epitaxial layer 1012 in the plurality of spaced portions SPC; and a plurality of PN junctions (not shown) formed between the second highly doped semiconductor well P+W2 and the first type SiC epitaxial layer 1012, wherein the plurality of PN junctions are configured to buffer a working high voltage under a reverse bias condition. The method S30 may further include the following steps of depositing a second isolation layer ISO2 on the first isolation layer ISO1 and the plurality of spaced portions SPC of the protection area base PA; etching the first isolation layer ISO1 and the second isolation layer ISO2 on the two sides GAL of each gate of the at least one gate GA, so that the first type highly doped epitaxial layer 1014 on the two sides GAL is exposed to form the first electrode E1, wherein the second type epitaxial layer 1013 on the two sides GAL serves as the active channel ACH, and the first electrode E1 is a source S1; depositing a connecting material precursor 1016 on the active cell region base ACR, the protection area base PA, and the bottom of the first type highly doped SiC layer 1011, wherein the connecting material precursor 1016 may be a nickel metal; etching the connecting material precursor 1016 on the protection area base PA; etching the connecting material precursor 1016 between the two gates GA to have a specific thickness 1017T; sintering the connecting material precursor 1016 with the specific thickness 1017T to form a connecting material 1017, wherein the connecting material 1017 is nickel silicide; as shown in Fig. 10, etching a gate contact pad (not shown) to form a gate contact pad opening (not shown), and filling a gate wire material (not shown) into the gate contact pad opening, wherein the gate wire material may be an aluminum metal; depositing a top metal layer TM on the second isolation layer ISO2 of the active cell region base ACR and on the connecting material 1017 between two gates GA, wherein the top metal layer TM serves as a source electrode pad SPD; and depositing a protection layer PAL on the protection area base PA and a part of the top metal layer TM in the active cell region ACR.

## Claims

1. A method of manufacturing a power transistor (10), **characterized by** comprising the following steps:
providing a silicon carbide semiconductor substrate (101), wherein the silicon carbide semiconductor substrate (101) comprises a first type highly doped silicon carbide layer (1011), a first type silicon carbide epitaxial layer (1012), a second type silicon carbide epitaxial layer (1013), and a first type highly doped silicon carbide epitaxial layer (1014), wherein the second type silicon carbide epitaxial layer (1013) is pre-arranged on the first type silicon carbide epitaxial layer (1012) to serve as an active channel of the power transistor (10), and the first type highly doped silicon carbide epitaxial layer (1014) is pre-arranged on the second type silicon carbide epitaxial layer (1013) to serve as a first electrode (E1) of the power transistor (10); and
etching the first type highly doped silicon carbide epitaxial layer (1014), the second type silicon carbide epitaxial layer (1013), and the first type silicon carbide epitaxial layer (1012) to form a protection area base (PA) and an active cell region base (ACR) having at least one trench (TCH).

2. The method of Claim 1, **characterized in that** the active cell region base (ACR) has a plurality of trenchs (TCH), and the method further comprises:
depositing a gate isolation layer (GO) on the protection area base (PA) and the active cell region base (ACR);
depositing a polysilicon (PLY) on each of the plurality of trenchs (TCH) to form at least one gate (GA);
depositing a first isolation layer (ISO1) on the protection area base (PA) and the active cell region base (ACR);
etching the first isolation layer (ISO1), the gate isolation layer (GO), the first type highly doped silicon carbide epitaxial layer (1014), and the second type silicon carbide epitaxial layer (1013) located between any two of the plurality of trenchs (TCH) and between the active cell region base (ACR) and the protection area base (PA); and
etching the first isolation layer (ISO1) and the gate isolation layer (GO) on the protection area base (PA) at a plurality of intervals to form a plurality of spaced portions (SPC).

3. The method of Claim 2, **characterized by** further comprising:
implanting a second type carrier into the first type silicon carbide epitaxial layer (1012) located between any two of the plurality of trenchs (TCH), between the active cell region base (ACR) and the protection area base (PA), and at the plurality of spaced portions (SPC) of the protection area base (PA) to form a plurality of second type highly doped semiconductor wells, wherein the plurality of second type highly doped semiconductor wells comprise:
a first highly doped semiconductor well (P+W1) in the first type silicon carbide epitaxial layer (1012) between any two of the plurality of trenchs (TCH);
a second highly doped semiconductor well (P+W2) in the first type silicon carbide epitaxial layer (1012) between the active cell region base (ACR) and the protection area base (PA); and
a third highly doped semiconductor well (P+W3) in the first type silicon carbide epitaxial layer (1012) at the plurality of spaced portions (SPC),
wherein a plurality of PN junctions are formed between the second highly doped semiconductor wells (P+W2) and the first type silicon carbide epitaxial layer (1012), and the plurality of PN junctions are configured to buffer a working high voltage in a reverse bias.

4. The method of Claim 3, **characterized by** further comprising:
depositing a second isolation layer (ISO2) on the first isolation layer (ISO1) and on the plurality of spaced portions (SPC) of the protection area base (PA);
etching the first isolation layer (ISO1) and the second isolation layer (ISO2) on two sides of each of the at least one gate (GA) to expose the first type highly doped silicon carbide epitaxial layer (1014) on the two sides to form the first electrode (E1), wherein the second type silicon carbide epitaxial layer (1013) on the two sides serves as the active channel;
depositing a connecting material precursor (1016) on the active cell region base (ACR), the protection area base (PA), and a bottom (1011B) of the first type highly doped silicon carbide layer (1011);
etching the connecting material precursor (1016) on the protection area base (PA) and etching the connecting material precursor (1016) between adjacent two of the at least one gate (GA) so that the connecting material precursor (1016) has a specific thickness (1017T); and
sintering the connecting material precursor (1016) having the specific thickness (1017T) to form a connecting material (1017).

5. The method of Claim 4, **characterized in that** the first electrode (E1) is a source (S1), the connecting material precursor (1016) is a nickel metal, and the connecting material (1017) is a nickel silicide.

6. The method of Claim 4, **characterized by** further comprising:
etching a gate contact pad to form a gate contact pad opening;
filling a gate wire material into the gate contact pad opening;
depositing a top metal layer (TM) on the second isolation layer (ISO2) of the active cell region base (ACR) and on the connecting material (1017) between the adjacent two gates (GA); and
depositing a protection layer (PAL) on the protection area base (PA) and on a part of the top metal layer (TM) of the active cell (122).

7. The method of Claim 6, **characterized in that** the gate wire material is an aluminum metal, and the top metal layer (TM) serves as a source electrode pad (SPD).

8. The method of Claim 2, **characterized in that**:
the silicon carbide semiconductor substrate (101) further comprises:
a buffer layer (1015) connecting the first type highly doped silicon carbide layer (1011) and the first type silicon carbide epitaxial layer (1012); and
a bottom metal layer (BM) disposed under the first type highly doped silicon carbide layer (1011) to serve as a second electrode (E2) of the power transistor (10);
the first type highly doped silicon carbide layer (1011) is an N-type highly doped silicon carbide layer, the first type silicon carbide epitaxial layer (1012) is an N-type silicon carbide epitaxial layer, the second type silicon carbide epitaxial layer (1013) is a P-type silicon carbide epitaxial layer, and the first type highly doped silicon carbide epitaxial layer (1014) is an N-type highly doped silicon carbide epitaxial layer; and
a width of the plurality of spaced portions (SPC) in the protection area base (PA) is wider as it is closer to an edge of the protection area base (PA).

9. The method of Claim 8, **characterized in that**:
the second electrode (E2) is a drain (D1) of the power transistor (10);
a quantity and the width of the plurality of spaced portions (SPC) depend on a withstand voltage specification of the power transistor (10); and
the second type silicon carbide epitaxial layer (1013) and the first type highly doped silicon carbide epitaxial layer (1014) are pre-arranged on the first type silicon carbide epitaxial layer (1012) before all photolithography processes and all etching processes to avoid or reduce subsequent high-energy carrier implantation.

10. A power transistor (10), **characterized by** comprising:
a semiconductor substrate (101) comprising a first type epitaxial layer (121);
an active cell (122) disposed on the semiconductor substrate (101) and comprising at least one gate (GA), wherein on two sides of the at least one gate (GA), there are a second type epitaxial portion (123) on the first type epitaxial layer (121) and a first type highly doped epitaxial portion (124) on the second type epitaxial portion (123);
a protection structure (PS) disposed on the semiconductor substrate (101); and
a transition structure (TS) disposed between the active cell (122) and the protection structure (PS), and having a second type highly doped epitaxial portion (125).

11. The power transistor (10) of Claim 10, **characterized in that**:
the active cell (122) comprises a plurality of gates (GA) and a plurality of second type epitaxial portions (123);
the active cell (122) further comprises a second type highly doped epitaxial portion (125) disposed between any two of the plurality of gates (GA) and between any two of the plurality of second type epitaxial portions (123), wherein the second type highly doped epitaxial portion (125) is configured to serve as a body base (BB) of the power transistor (10), and the second type epitaxial portions (123) serve as an active region of the power transistor (10); and
the transition structure (TS) is configured to serve as a single-level PN diode to protect the power transistor (10) when the single-level PN diode is reverse-biased.

12. The power transistor (10) of Claim 11, **characterized in that** the transition structure (TS) includes:
the first type epitaxial layer (121);
a first position portion (1251) disposed on the first type epitaxial layer (121);
a second position portion (1253) disposed on the first type epitaxial layer (121); and
a step transition portion (1252) disposed on the first type epitaxial layer (121) and connecting the first position portion (1251) and the second position portion (1253), wherein the first position portion (1251), the second position portion (1253) and the step transition portion (1252) forms a step.

13. The power transistor (10) of Claim 12, **characterized in that**:
the semiconductor substrate (101) is a silicon carbide semiconductor substrate (101), and the power transistor (10) is a trench power transistor;
the first type is N-type, and the second type is P-type;
each of the plurality of gates (GA) comprises a polysilicon (PLY) disposed in a trench (TCH) and a gate isolation layer (GO) disposed on two sides and a bottom of the trench (TCH);
the first type highly doped epitaxial portions (124) on the two sides of each of the plurality of gates (GA) serve as a source (S1) of the power transistor (10);
the active cell (122) further comprises a first isolation layer (ISO1) disposed on the plurality of gates (GA) and a top metal layer (TM) disposed on the active cell (122), wherein the top metal layer (TM) serves as a source electrode pad (SPD), the first isolation layer (ISO1) is configured to insulate the gates (GA) from the source electrode pad (SPD), and a part of the source (S1) is electrically connected to the source electrode pad (SPD); and
the silicon carbide semiconductor substrate (101) further comprises a buffer layer (1015), a first type highly doped silicon carbide layer (1011), and a bottom metal layer (BM), wherein the buffer layer (1015) connects the first type highly doped silicon carbide layer (1011) and the first type epitaxial layer (121), and the bottom metal layer (BM) serves as a drain (D1) of the power transistor (10).

14. The power transistor (10) of Claim 13, **characterized in that** the protection structure (PS) is configured to serve as a multi-level PN diode to protect the power transistor (10) when the multi-level PN diode is reverse-biased.

15. The power transistor (10) of Claim 13, **characterized in that** the protection structure (PS) comprises:
a plurality of floating edge rings (FR), wherein each floating edge ring (FR) of the plurality of floating edge rings (FR) comprises a second type highly doped epitaxial portion (125), and the second type highly doped epitaxial portion (125) forms a PN semiconductor junction with a part of the first type epitaxial layer (121);
a second isolation layer (ISO2) configured to insulate the plurality of floating edge rings (FR) from the source electrode pad (SPD); and
a protection layer (PAL) disposed on the plurality of floating edge rings (FR) and on the source electrode pad (SPD).
